Europäisches Patentamt

European Patent Office

Office européen des brevets

(19)

(11) EP 0 539 756 B1

(12) **EUROPÄISCHE PATENTSCHRIFT**

(45) Veröffentlichungstag und Bekanntmachung des Hinweises auf die Patenterteilung:
**15.01.1997 Patentblatt 1997/03**

(51) Int Cl.⁶: **H05K 1/03**, H01L 23/15, C04B 35/48

(21) Anmeldenummer: **92116873.8**

(22) Anmeldetag: **02.10.1992**

(54) **Substratmaterial für Mikrostreifenleiterschaltung und Verfahren zur Herstellung von Substraten**

Substrate material for a microstripline circuit and method for preparing substrates

Matériau de substrat pour un circuit de lignes à microruban et procédé pour préparer des substrats

(84) Benannte Vertragsstaaten:
**BE CH DE ES FR GB IT LI NL SE**

(30) Priorität: **18.10.1991 DE 4134462**

(43) Veröffentlichungstag der Anmeldung:
**05.05.1993 Patentblatt 1993/18**

(73) Patentinhaber: **ROBERT BOSCH GMBH**
**70442 Stuttgart (DE)**

(72) Erfinder:
• **Krueger, Guenther, Dr. Phys.-Chem.**
**W-7251 Weissach-Flacht (DE)**
• **Pfizenmaier, Heinz, Dipl.-Ing.**
**W-7250 Leonberg (DE)**

• **Stolten, Detlef**
**W-7772 Uhldingen 3 (DE)**

(56) Entgegenhaltungen:
DE-A- 3 942 666          GB-A- 1 268 811
GB-A- 1 268 811

• PATENT ABSTRACTS OF JAPAN, Bd. 13, Nr. 364 (E-805)14. August 1989;& JP-A-1120709
• MICROELECTRONICS JOURNAL Bd. 15, Nr. 2, M rz 1984, LUTON GB Seiten 44 - 52 CLIVE NEWPORT 'A review if thick film microwave integrated circuit technology'
• PATENT ABSTRACTS OF JAPAN, Bd. 16, Nr. 362 (C-971)5. August 1992;& JP-A-4114919
• PATENT ABSTRACTS OF JAPAN, Bd. 16, Nr. 441 (E-1264)14. September 1992;& JP-A-4154003

EP 0 539 756 B1

**Beschreibung**

Stand der Technik

Die Erfindung geht aus von Substratmaterialien für Mikrostreifenleiterschaltungen nach der Gattung des Hauptanspruchs, vgl. GB-A-1 286 811.

Mikrostreifenleiterschaltungen werden in zunehmendem Maße in der Richtfunk-, Satelliten- und Funkortungstechnik, in der industriellen Meß- und Prüftechnik sowie in der Konsumelektronik verwendet.

Vom strukturellen Aufbau her bestehen Mikrostreifenleiterschaltungen im wesentlichen aus einem Substrat, d. h. einer verlustarmen dielektrischen Trägerplatte, auf der das strukturierte Mikrostreifenleiter-Netzwerk angeordnet ist, sowie aus hybriden Elementen, die als fertige Bauteile nach der Herstellung der Mikrostreifenleiter in getrennten Verfahrensschritten in die Schaltung eingesetzt werden. Dem Substrat kommen dabei folgende Aufgaben zu:

- mechanischer Träger der Schaltung sowie mechanische Verbindung mit dem Schaltungsgehäuse,
- wellenleitendes Medium bei den Streifenleitern,
- technologisches Medium für die Verfahrensschritte zur Herstellung von Mikrostreifenleitungen, Widerständen und Kondensatoren.

Aluminiumoxidkeramik, das weitaus am häufigsten verwendete Substratmaterial, zeichnet sich durch gute mechanische Eigenschaften, insbesondere durch eine Festigkeit von ca. 400 - 450 $Nmm^{-2}$ aus. Weil der Miniaturisierungsgrad von Mikrostreifenleiterschaltungen jedoch wesentlich von der Dielektrizitätszahl des Substrats abhängt, sollten Substratmaterialien möglichst hohe Dielektrizitätszahlen aufweisen. Aluminiumoxidkeramik, mit einer Dielektrizitätszahl $\varepsilon = 10$ ist daher für eine hohe Miniaturisierung weniger geeignet als eine Keramik mit zum Beispiel $\varepsilon = 38$.

Es wurden bereits Titanat-Keramiken als Substratmaterialien entwickelt, die hohe Dielektrizitätszahlen, im Bereich von 20 - 90 aufweisen und somit eine weitere Miniaturisierung ermöglichen. Die mechanischen Eigenschaften, insbesondere die Festigkeit, sind jedoch unbefriedigend. Zudem können Titanatkeramiken bislang nicht in ausreichender Kornfeinheit und somit niedriger Porosität erhalten werden. Für eine geringe Exemplarsteuerung der Mikrostreifenleiterschaltungen muß jedoch das Substrat ein feinkörniges Gefüge aufweisen.

Erfindung

Ein Substrat material gemäß der Erfindung ist im Anspruch 1 angegeben. Die Ansprüche 2 bis 6 beziehen sich auf besondere Ausführungsarten dieses Substratmaterials. Die Ansprüche 7 bis 9 betreffen Verfahren zur Herstellung dieses Substratmaterials.

Die erfindungsgemäße Calciumzirkonatkeramik weist sehr gute Eigenschaften als mechanischer Träger, wellenleitendes Medium und technologisches Medium für integrierte Mikrowellenschaltungen auf. Calciumzirkonat-Keramiken haben eine Dielelektrizitätszahl von ca. 38 und erlauben somit eine gegenüber $Al_2O_3$ um den Faktor $\sqrt{38/10}$ höhere Miniaturisierung. Sie können zudem mit guter mechanischer Festigkeit sowie mit feinkörnigem Gefüge erhalten werden.

Ein Substratmaterial mit ausgezeichneten Eigenschaften ist aus dem handelsüblichen und vergleichsweise preiswerten Calciumzirkonat-Pulver in einfacher Weise, entsprechend den Verfahrensansprüchen, herstellbar. Insbesondere wird erfindungsgemäß mit einfachen Mitteln eine für die Verwendung als Substratmaterial vorteilhaft geringe Porosität erreicht. Dabei wird die Korngröße des gesinterten Materials kleiner als 5 $\mu m$, insbesondere auf etwa 1 bis 2 $\mu m$ gehalten.

Ein Calciumzirkonat-Pulver wird mit einem Molverhältnis Ca : Zr kleiner als 1, insbesondere von etwa 0,93 zu 1, einzusetzen. Dadurch wird in vorteilhafter Weise ein zu starkes Ansteigen der Sintertemperatur und somit der Korngröße verhindert. Weiterhin ist es besonders vorteilhaft, wenn das Ausgangsmaterial Sinterhilfsmittel, insbesondere Aluminiumoxid, Siliziumdioxid oder Magnesiumoxid enthält, die das Sinterverhalten weiter verbessern.

Die erfindungsgemäßen Verfahren kennzeichnen sich durch die einfache Durchführbarkeit. Insbesondere kann an Luft gesintert werden.

Beschreibung eines Ausführungsbeispiels

Ein handelsübliches Calciumzirkonat-Pulver, mit einem Molverhältnis Ca : Zr von 0,93 : 1, das 1,2 Mol.-% Siliziumdioxid und 0,50 Mol.-% Aluminiumoxid enthält, wird unter Zusatz von 1 Gew.-% Wachsemulsion als Binder und 0,25 Gew.-% Dispergierhilfsmittel auf der Basis von Ligninsulfonat 2 Stunden lang auf einem Walzenstuhl einer Schlickermahlung unterworfen. Der Schlicker hatte 60 % Feststoffgehalt. Das Rohstoffgemisch wird gefriergetrocknet und anschließend bei etwa 300 bar axial verpreßt. Der Preßkörper wird anschließend auf geeigneten Brennunterlagen bei 1385 $\pm$ 10° C etwa 2 Stunden lang gesintert, wobei Aufheiz- und Abheizgeschwindigkeiten von etwa 100° C $h^{-1}$ ein-

gehalten werden.

Es wird eine plättchenförmige Calziumzirkonat-Keramik mit einer Dicke von 0,2 bis 3 mm, bevorzugt 1 mm, erhalten, die optimale Eigenschaften als Substratmaterial für Mikrostreifenleiterschaltungen aufweist. Insbesondere wird, wie aus der nachfolgenden Tabelle zu erkennen ist, eine gute mechanische Festigkeit sowie eine niedrige, geschlossene Porosität erreicht.

Tabelle:

| Änderung der Festigkeit, Porosität und Fuchsineinfärbung mit der Sintertemperature | | | |
|---|---|---|---|
| Sintertemperatur (°C) | Festigkeit (N mm$^{-2}$) | Porosität (%) | Fuchsineinfärbung |
| 1350 | 150 | 8,1; offen | s. stark |
| 1385 | 300 | 5,0; geschlossen | keine |
| 1400 | 230 | 2,9; geschlossen | s. schwach |
| 1450 | 120 | 2,6; geschlossen | schwach |
| 1500 | 85 | 2,5; geschlossen | schwach |
| 1600 | 70 | 2,5; geschlossen | stärker |

Die Tabelle zeigt, daß mit dem Ansteigen der Sintertemperatur bis auf etwa 1380° C die Festigkeit bis etwa 300 Nmm$^{-2}$ zunimmt, um bei höheren Sintertemperaturen wieder abzufallen. Der Anstieg der Festigkeit ist auf eine Abnahme der Porosität zurückzuführen, die sich auch durch die Abnahme der Fuchsineinfärbung zeigt. Steigt die Sintertemperatur jedoch über etwa 1390 bis 1400° C an, so nimmt die Korngröße soweit zu, daß Risse in den Körnern auftreten, die die Festigkeit extrem stark absenken. Die Korngröße sollte daher nicht wesentlich über 5 μm liegen. Besonders vorteilhaft ist eine Korngröße von etwa 1 bis 2 μm. Die Ausbildung von Rissen bei zu großem Anstieg der Sintertemperatur und damit der Korngröße zeigt sich auch durch die Zunahme der Fuchsineinfärbung bei höheren Sintertemperaturen.

Die beschriebenen Calziumzirkonatkeramik-Plättchen sind hervorragend als Substratmaterial für Mikrostreifenleiterschaltungen geeignet.

Bei anderen Zusammensetzungen der Ausgangsstoffe, insbesondere bei Verwendung anderer Flußmittel oder Änderung der Flußmittelanteile kann die optimale Sintertemperatur, bei der maximale Festigkeit und fehlende Fuchsineinfärbung erreicht werden, andere Werte haben.

Ausgehend von den genannten Parametern - maximale Festigkeit und fehlende Fuchsineinfärbung - kann die optimale Sintertemperatur für Ausgangsstoffe, die von dem obigen Beispiel abweichen, eingestellt werden.

Die erfindungsgemäßen Substrate für Mikrostreifenleiterschaltungen können durch weitere Herstellungsverfahren, wie zum Beispiel Kalandrieren, Extrudieren, Hoch- und Niederdruckspritzgießen, Pressen oder Schlickerguß erhalten werden.

**Patentansprüche**

1. Substratmaterial für Mikrostreifenleiterschaltungen, welches im wesentlichen Calciumzirkonat enthält, dadurch gekennzeichnet, daß Calcium gegenüber Zirkonium im Molverhältnis von 0,9:1 bis kleiner als 1:1 vorliegt.

2. Substratmaterial nach Anspruch 1, dadurch gekennzeichnet, daß das Calcium gegenüber Zirkonium im Molverhältnis von 0,93:1 vorliegt.

3. Substratmaterial nach Anspruch 1 oder 2, dadurch gekennzeichnet, daß das Zirkonium bis zu einem Anteil von 5 % durch Hafnium ersetzt ist.

4. Substratmaterial nach einem der vorhergehenden Ansprüche, dadurch gekennzeichnet, daß es Sinterhilfsmittel enthält.

5. Substratmaterial nach Anspruch 4, dadurch gekennzeichnet, daß als Sinterhilfsmittel einer oder mehrere der Stoffe $SiO_2$, vorzugsweise zwischen 1 und 2,5 Mol-%, insbesondere 1,2 Mol-%, und/oder $Al_2O_3$, vorzugsweise 0,5 Mol-% und/oder MgO verwendet werden.

6. Substratmaterial nach einem der vorhergehenden Ansprüche, gekennzeichnet durch eine Korngröße kleiner als 5 μm, insbesondere von etwa 1 - 2 μm.

**7.** Verfahren zur Herstellung von Substraten nach einem der vorhergehenden Ansprüche, dadurch gekennzeichnet, daß der pulverförmige Ausgangsstoff, enthaltend Calciumoxid und Zirkoniumdioxid sowie Sinterhilfsmittel, gegebenenfalls unter Zusatz von Bindern und Dispergierhilfsmitteln gemahlen, gegebenenfalls gefriergetrocknet, axial verpreßt und anschließend an Luft gesintert wird, vorzugsweise bei 1350 ± 10 °C, auf fehlende Fuchsineinfärbung, etwa 2 Stunden lang.

**8.** Verfahren nach Anspruch 7, dadurch gekennzeichnet, daß drucklos gesintert wird.

**9.** Verfahren zur Herstellung von Substraten nach einem der Ansprüche 1 bis 6, dadurch gekennzeichnet, daß der pulverförmige Ausgangsstoff, enthaltend Calciumoxid und Zirkoniumdioxid sowie Sinterhilfsmittel, gegebenenfalls unter Zusatz von Bindern und Dispergierhilfsmitteln, gemahlen, zu Folien vergossen, gebrannt und gesintert wird.

**Claims**

**1.** Substrate material for micro-stripline circuits, which essentially contains calcium zirconate, characterized in that, relative to zirconium, calcium is present in a molar ratio of 0.9:1 to less than 1:1.

**2.** Substrate material according to Claim 1, characterized in that, relative to zirconium, the calcium is present in a molar ratio of 0.93:1.

**3.** Substrate material according to Claim 1 or 2, characterized in that the zirconium is replaced up to a proportion of 5% by hafnium.

**4.** Substrate material according to one of the preceding claims, characterized in that it contains a sintering aid.

**5.** Substrate material according to Claim 4, characterized in that one or more of the materials $SiO_2$, preferably between 1 and 2.5 mol%, in particular 1.2 mol%, and/or $Al_2O_3$, preferably 0.5 mol% and/or MgO are used as the sintering aid.

**6.** Substrate material according to one of the preceding claims, characterized by a particle size of less than 5 µm, in particular of approximately 1-2 µm.

**7.** Process for the production of substrates according to one of the preceding claims, characterized in that the powdered starting material, containing calcium oxide and zirconium dioxide and a sintering aid, optionally with the addition of binders and dispersing agents is ground, optionally freeze-dried, axially compressed and subsequently sintered in air, preferably at 1350 ± 10°C, until fuchsin coloration disappears, for approximately 2 hours.

**8.** Process according to Claim 7, characterized in that the sintering is carried out without pressure.

**9.** Process for the production of substrates according to one of Claims 1 to 6, characterized in that the powdered starting material, containing calcium oxide and zirconium dioxide and a sintering aid, optionally with the addition of binders and dispersing agents, is ground, cast into sheets, fired and sintered.

**Revendications**

**1.** Matériau de substrat pour un circuit de lignes à micro-ruban, qui contient essentiellement du zirconate de calcium, caractérisé en ce que
le calcium est présent par rapport au zirconium dans le rapport molaire de 0,9:1 jusqu'à moins que 1:1.

**2.** Matériau de substrat selon la revendication 1,
caractérisé en ce que
le calcium est présent vis-à-vis du zirconium dans le rapport molaire de 0,93:1.

**3.** Matériau de substrat selon la revendication 1 ou 2,
caractérisé en ce que
le zirconium peut être remplacé par du hafnium jusqu'à une proportion de 5 %.

4. Matériau de substrat selon une des revendications précédentes,
caractérisé en ce que
il contient un adjuvant de frittage.

5. Matériau de substrat selon la revendication 4,
caractérisé en ce que
on utilise comme adjuvant de frittage une ou plusieurs des matières $SiO_2$, de préférence entre 1 et 2,5 % molaire,
en particulier 1,2 % molaire, et/ou $Al_2O_3$, de préférence 0,5 % molaire et/ou MgO.

6. Matériau de substrat selon une des revendications précédentes,
caractérisé par,
une grandeur de grains inférieure à 5 $\mu$m, en particulier environ de 1 à 2 $\mu$m.

7. Procédé de préparation de substrats selon une des revendications précédentes,
caractérisé en ce que
la matière première pulvérulente, contenant de l'oxyde de calcium et du dioxyde de zirconium ainsi que des adjuvants de frittage, éventuellement avec addition de liants et d'adjuvants de dispersion est moulue, éventuellement lyophilisée, comprimée axialement et ensuite est frittée à l'air, de préférence à 1350 ± 10°C, pendant environ 2 heures, pour obtenir l'absence d'inhibition colorée de fuchsine.

8. Procédé de préparation de substrats selon la revendication 7,
caractérisé en ce que
on effectue le frittage sans pression.

9. Procédé de préparation de substrats selon une des revendications 1 à 6,
caractérisé en ce que
la matière première pulvérulente contenant de l'oxyde de calcium et du dioxyde de zirconium ainsi que des adjuvants de frittage, éventuellement avec addition de liants et d'adjuvants de dispersion, est broyée, coulée en feuilles, cuite et frittée.